# EUROPEAN PATENT APPLICATION

(11) **EP 4 671 776 A1**
(43) Date of publication of application: **31.12.2025**
(21) Application number: 24760508.2
(22) Date of filing: 06.02.2024
(51) Int. Cl.: G01R 31/12, G01R 31/62, G01R 23/02, G01R 1/04

(54) **DEVICE FOR SENSING PARTIAL DISCHARGE OF TRANSFORMER**

(30) Priority: 21.02.2023 KR 20230022711
(71) Applicant: HD Hyundai Electric Co., Ltd, Seongnam-si 13553 (KR)
(72) Inventor: MIN, Byoung-Woon, Seongnam-si Gyeonggi-do 13553 (KR)
(74) Representative: Nederlandsch Octrooibureau
(86) International application number: PCT/KR2024/001702
(87) International publication number: WO 2024/177317

(57) **Abstract**

The present invention relates to a device for sensing a partial discharge of a transformer, the device detecting a partial discharge in a transformer and being capable of measuring the position thereof. The device for sensing a partial discharge of a transformer, according to one embodiment, may comprise: a case which is provided in the transformer and which has a hollow portion; an omni-directional first sensor which is disposed at one side in the case and which detects a partial discharge signal of the transformer; and a directional second sensor which is disposed at the other side in the case and which detects the partial discharge signal of the transformer.

## Description

### Technical Field

The present disclosure relates to a device for sensing a partial discharge of a transformer for detecting a partial discharge within a transformer and measuring a position thereof.

### Background Art

In general, a partial discharge occurs before an accident occurs due to a decrease in insulation performance of a transformer. Accordingly, when a partial discharge occurs, a defective part should be found, inspected and repaired.

To find a position of the partial discharge within a transformer, a method in which an inspector visually inspects the inside of the transformer or determines the position of the partial discharge within the transformer based on past experience, is used, but due to a nature of the sealed transformer housing, it is very difficult to find the position of the partial discharge within the transformer. Moreover, since the transformer should be stopped and the insulating oil drained to find the position of the partial discharge, there is a significant loss in terms of costs.

To solve such a problem, a method of estimating the location of the partial discharge using ultrasonic or ultra-high frequency signals in an operating transformer has been proposed. However, there is a problem that the ultrasonic signal level is low, making it difficult to measure a position thereof, and in particular, four or more sensors should be installed inside the transformer for highly accurate position measurement.

### Disclosure of Invention

### Technical Problem

An aspect of the present disclosure is to provide a device for sensing a partial discharge of a transformer for detecting a partial discharge within a transformer and measuring a position thereof.

### Solution to Problem

According to an aspect of the present disclosure, a device for sensing a partial discharge may include a case provided in a transformer and having a hollow portion; an omni-directional first sensor disposed on one side in the case, and detecting a partial discharge signal of the transformer; and a directional second sensor disposed on the other side in the case, and detecting the partial discharge signal of the transformer.

The first sensor and the at least one second sensor may be ultra-high frequency sensors.

The device for sensing a partial discharge may further include a third sensor disposed within the case and detecting light within the transformer.

The case may have a transparent window formed at least partially.

The device for a partial discharge may further include a first support pipe having a flange portion and a tubular extension portion; a second support pipe penetrating the extension portion and having the case fixed to one end thereof; and a signal line connector mounted on the other end of the second support pipe and capable of connecting a signal line.

The device for a partial discharge may be installed in a drain valve of the transformer.

### Advantageous Effects of Invention

According to an embodiment of the present disclosure, a partial discharge may be detected within a transformer, and a position thereof may be measured with high accuracy, without stopping operation of the transformer, thereby minimizing the time and economic loss required to find the position of the partial discharge.

In addition, according to an embodiment of the present disclosure, since it is possible to quickly find and take action regarding a defective part within a transformer when a partial discharge occurs, there is an effect of preventing an accident in the transformer in advance.

### Brief Description of Drawings

FIG. 1 is a front view and a partially enlarged cross-sectional view of a device for sensing a partial discharge according to an embodiment of the present disclosure.
FIG. 2 is a drawing illustrating a state in which a device for sensing a partial discharge according to an embodiment of the present disclosure is mounted on a transformer.

### Best Mode for Invention

Hereinafter, the present disclosure will be described in detail with reference to exemplary drawings. In adding reference numerals to components of each drawing, it should be noted that the same components are indicated by the same numerals even though displayed on different drawings.

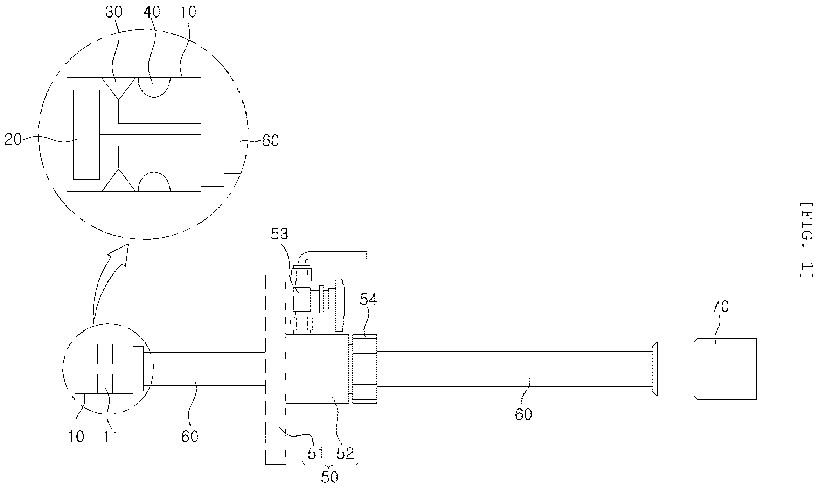

FIG. 1 is a front view and a partially enlarged cross-sectional view of a device for sensing a partial discharge according to an embodiment of the present disclosure.

A device for sensing a partial discharge of a transformer according to an embodiment of the present disclosure may include a case 10, an omni-directional first sensor 20, and a directional second sensor 30.

The case 10 may be formed to have a hollow portion to store components therein, and protect the components from various factors such as high voltage, insulating oil, etc. within the transformer. The case may be formed of a material which is strong and insulating, such as plastic, silicone, or ceramic.

The first sensor 20 may be disposed on one side in the case 10, and may detect a partial discharge signal of the transformer. The first sensor has omnidirectionality so that equal gain may be obtained in all directions, up and down, and horizontal.

For example, the first sensor 20 may be an ultra-high frequency (UHF) sensor. The first sensor may receive an electromagnetic wave signal radiated by a partial discharge in a UHF band of about 300 to 1600 MHz.

When a partial discharge occurs within a transformer, an electromagnetic signal is emitted in a wide frequency range. A first sensor 20 applied to the device for sensing a partial discharge according to an embodiment of the present disclosure receives an electromagnetic signal in the UHF band among the electromagnetic signals.

In this case, the first sensor 20 should efficiently detect a partial discharge signal from all sections within the transformer, and thus has omnidirectionality that can receive signals in all directions.

At least one second sensor 30 may be disposed on the other side in the case 10 to detect a partial discharge signal of the transformer. The second sensor has directionality so that a gain may be obtained in a specific direction.

For example, the second sensor 30 may be a UHF sensor. The second sensor may receive an electromagnetic signal radiated by a partial discharge in the UHF band of approximately 300 to 1600 MHz.

When a partial discharge occurs within a transformer, electromagnetic signals are emitted over a wide frequency range. A second sensor 30 applied to the device for sensing a partial discharge according to an embodiment of the present disclosure receives an electromagnetic wave signal in the UHF band among the electromagnetic wave signals.

Moreover, the second sensor 30 has directionality so that a partial discharge signal can be intensively detected from a specific section within the transformer.

The device for sensing a partial discharge according to an embodiment of the present disclosure may have at least two sensors 20 and 30 embedded therein, so that each sensor may detect a partial discharge signal, i.e., an electromagnetic wave signal in a UHF band, and may obtain distance information from an arrival time difference, a magnitude of the signal, and the like of the signal detected by the sensors.

Moreover, the second sensor 30 may gain from a specific direction, so that direction information may be acquired from a direction of the signal detected by the sensors.

Accordingly, since a distance between the device for sensing a partial discharge and a defect source where a partial discharge occurred, and a direction of the defect source with respect to the device for sensing a partial discharge may be known, a location of the defect source generating the partial discharge signal within the transformer may be measured.

In the prior art, at least four sensors should be installed inside a transformer to measure a position of a partial discharge. However, the device for sensing a partial discharge according to an embodiment of the present disclosure may have the advantage of measuring the position of the partial discharge, with much higher accuracy than conventionally using only two sensors, that is, a directional second sensor along with an omni-directional first sensor.

In addition, due to the above-described configuration and operation, the device for sensing a partial discharge according to an embodiment of the present disclosure may achieve the effect of significantly reducing the time and cost required to find the position of the partial discharge.

The device for sensing a partial discharge of a transformer according to an embodiment of the present disclosure may further include a third sensor 40 which is disposed within a case 10 and detects light within the transformer. As the third sensor, a light sensor or a light intensity sensor, such as a phototransistor, a photoresistor, a photodiode, etc. may be adopted.

In addition, for the light detection of the third sensor 40, a window 11 formed of a transparent material which is at least partially light-transmittable may be formed in the case 10. The window may be disposed at least in a portion of the case corresponding to the third sensor.

By mounting a third sensor 40 comprising a light sensor or a light intensity sensor on the device for sensing a partial discharge, it is possible to detect an optical signal of an arc generated within the transformer. Accordingly, the device for sensing a partial discharge according to an embodiment of the present disclosure may distinguish between an arc and a partial discharge occurring within a transformer.

Meanwhile, a device for sensing a partial discharge according to an embodiment of the present disclosure may be installed in a drain valve 2 of a transformer housing 1. To this end, the device for sensing a partial discharge of a transformer according to an embodiment of the present disclosure may further include a first support pipe 50, a second support pipe 60, and a signal line connector 70.

The first support pipe 50 may be coupled to the drain valve 2 of the transformer. To this end, the first support pipe may include a flange portion 51 and a tubular extension portion 52.

The flange portion 51 may function as a coupling portion having a more extended diameter than that of the extension portion 52 of the first support pipe 50 for connection with the drain valve 2. The flange portion may include a plurality of bolt holes (not shown) formed at regular intervals in a circumferential direction.

Bolts, nuts, and the like, may be fastened to the flange portion 51 together with a corresponding flange of the drain valve 2, so that the first support pipe 50 may be connected to the drain valve.

The extension portion 52 extends from one side surface of the flange portion 51 and has a hollow structure with a hollow interior. Thereby, the second support pipe 60 may be installed and supported on the first support pipe 50 by penetrating a hollow extension portion.

The extension portion 52 may further be provided with an exhaust valve 53 and a tightening nut 54.

The exhaust valve 53 may be opened to discharge air that may be introduced when installing the device for sensing a partial discharge of the present disclosure.

After the second support pipe 60 penetrates through the first support pipe 50 and is inserted into the transformer housing 1 through the drain valve 2, the tightening nut 54 may tighten an opening of the extension portion 52 so that an insertion length of the second support pipe 60 is fixed.

The second support pipe 60 may be formed as a long tubular member with a hollow interior. A case 10 may be fixed to one end of the second support pipe by, for example, screwing, bonding, or the like.

The second support pipe 60 may not only penetrate the extension portion 52 of the first support pipe 50, but may also be formed to be relatively movable with respect to the extension portion of the first support pipe. When the second support pipe penetrates through the first support pipe and is inserted into the transformer housing 1 through the drain valve 2 and then the tightening nut 54 tightens an opening of the extension portion, an insertion length of the second support pipe within the transformer housing, in other words, the positions of the case 10 and sensors 20, 30, and 40 within the transformer housing, may be fixed.

The signal line connector 70 may be mounted on the other end of the second support pipe 60. Output lines of each of the sensors 20, 30, and 40 constituting the device for sensing a partial discharge of the present disclosure may be connected to the inside of the signal line connector, and a signal line (not shown) extending to the outside of the transformer and connected to a signal analysis device may be connected to the outside of the signal line connector.

However, the output of the signal is not necessarily limited to wired communication, and for example, when the signal is output from the device for sensing a partial discharge of the present disclosure to the signal analysis device via wireless communication, the signal line and the signal line connector may be omitted.

Next, a method for installing a device for sensing a partial discharge according to an embodiment of the present disclosure is briefly described.

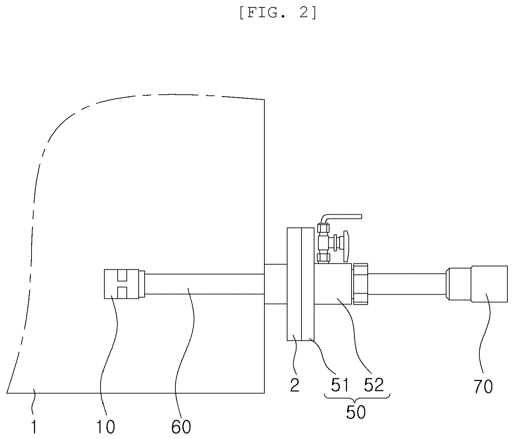

FIG. 2 is a drawing illustrating a state in which a device for sensing a partial discharge according to an embodiment of the present disclosure is mounted on a transformer.

After preparing a device for sensing a partial discharge, a worker holds a flange portion 51 and pulls a second support pipe 60 to bring contact with the case 10 and the flange portion 51 as close as possible. A drain valve 2 of a transformer housing 1 and the device for sensing a partial discharge may be combined. For example, the flange portion 51 of the first support pipe 50 and the flange of the drain valve 2 may be fastened by bolts and nuts, etc.

Next, the drain valve 2 is opened to check for leakage between the first support pipe 50 and the drain valve 2.

Thereafter, the worker pushes the second support pipe 60 toward the drain valve 2, so that the case 10 and sensors 20, 30, and 40 reach the desired position within the transformer housing 1. By tightening an opening with a tightening nut 54 of the extension portion 52 so that they can be fixed at the corresponding position, a position of the second support pipe relative to the first support pipe 50 and an insertion length of the second support pipe within the transformer housing may be fixed.

Next, an exhaust valve 53 of the extension portion 52 is opened to discharge air that may be introduced during installation. This prevents bubbles from forming in insulating oil within the transformer housing 1.

In this manner, a device for sensing a partial discharge according to an embodiment of the present disclosure may be installed in a transformer.

Therefore, the device for sensing a partial discharge according to an embodiment of the present disclosure can obtain the advantage that can be installed in an operating transformer without the need for a dedicated installation structure.

Once the installation of the device for sensing a partial discharge is completed, a signal line is connected to a signal line connector 70, thereby allowing the device for sensing a partial discharge to be electrically connected to a signal analysis device.

The signal analysis device may analyze a partial discharge signal and/or optical signal provided by the device for sensing a partial discharge to distinguish between an arc and a partial discharge occurring within the transformer and easily and precisely measure a position of a defect source generating a partial discharge signal within the transformer.

As described above, according to the device for sensing a partial discharge according to an embodiment of the present disclosure, when a partial discharge occurs, it is possible to quickly find a defective part within the transformer and take action, so that it has the effect of preventing accidents of the transformer in advance.

The description described above is merely an example of the technical idea of the present disclosure, and it will be apparent to those skilled in the art that modifications and variations could be made without departing from the scope of the present disclosure as defined by the appended claims.

Accordingly, the embodiments disclosed in this specification and drawings are not intended to limit the technical idea of the present disclosure but to explain the same, and the scope of the technical idea of the present disclosure is not limited by these embodiments. The scope of protection of the present disclosure should be interpreted by the claims below, and all technical ideas within a scope equivalent thereto should be interpreted as being included in the scope of the rights of the present disclosure.

### Industrial Applicability

The present disclosure is useful for finding a defective part, and performing inspection and repair when a partial discharge occurs within a transformer during operation.

## Claims

1. A device for sensing a partial discharge, comprising:
a case provided in a transformer and having a hollow portion;
an omni-directional first sensor disposed on one side in the case, and detecting a partial discharge signal of the transformer; and
a directional second sensor disposed on the other side in the case, and detecting the partial discharge signal of the transformer.

2. The device for sensing a partial discharge of claim 1, wherein the first sensor and the at least one second sensor are ultra-high frequency (UHF) sensors.

3. The device for sensing a partial discharge of claim 1, further comprising:
a third sensor disposed within the case and detecting light within the transformer.

4. The device for sensing a partial discharge of claim 3, wherein the case has a transparent window formed at least partially.

5. The device for sensing a partial discharge of claim 1, further comprising:
a first support pipe having a flange portion and a tubular extension portion;
a second support pipe penetrating the extension portion and having the case fixed to one end thereof; and
a signal line connector mounted on the other end of the second support pipe and capable of connecting a signal line.

6. The device for sensing a partial discharge of claim 5, wherein the device for sensing a partial discharge is installed in a drain valve of the transformer.
